# EUROPEAN PATENT APPLICATION

(11) **EP 2 814 033 A1**
(43) Date of publication of application: **17.12.2014**
(21) Application number: 14169458.8
(22) Date of filing: 22.05.2014
(51) Int. Cl.: G11C 7/10

(54) **Data transfer device, buffering circuit, and buffing method**

(30) Priority: 13.06.2013 JP 2013124533
(71) Applicant: FUJITSU LIMITED, Kawasaki-shi, Kanagawa 211-8588 (JP)
(72) Inventor: Kitahara, Yoshihiro, Kanagawa, 211-8588 (JP)
(74) Representative: Hoffmann Eitle

(57) **Abstract**

A data transfer device (2) has a first bank (31) which has a first bank first memory (311) and a first bank second memory (312), a second bank (32) which has a second bank first memory (321) and a second bank second memory (322), and a control circuit (60). Write and read operations of both the first bank (31) and second bank (32) are performed in the reference period, and alternately changes to the write state and to the read state in the phase opposite to each other. The control circuit (60) controls the first bank (31) and the second bank (32) so that input data groups are stored sequentially in the first bank (31) and in the second bank (32) and the stored data groups are read sequentially.

## Description

### FIELD

The present invention relates to a data transfer device, a buffering circuit, and a buffering method.

### BACKGROUND

It is known to form FIFO (First In First Out) using a memory having a plurality of banks. In a FIFO having a plurality of banks, by reading data stored in a bank different from another bank to which data is being written, write and read operations are performed asynchronously.

Further, there is known a storage method in which data stored in a memory, such as a RAM (Random Access Memory), is read and data is written to the memory in one period of a clock signal. In this storage method, by providing a timing signal whose write period of time and read period of time change in at least 1/2 of one period of the clock signal to the memory, read of data and write of data are performed in one period of the clock signal.

### Related Documents

[Patent Document 1] Japanese Laid Open Patent Document No. 2001-307475
[Patent Document 2] Japanese Laid Open Patent Document No. H6-301590

### SUMMARY

However, the conventional FIFO has a problem that it is difficult to store data having a clock period shorter than the time during which data is written to a memory. Thus, an object of the present invention is to provide a data transfer device capable of storing data having a clock period shorter than the time during which data is written to a memory.

A data transfer device has a first bank, a second bank, and a control circuit. The data transfer device sequentially writes and stores data groups transferred in a data period and reads and outputs the data groups in the order of storage. An input data clock transfer circuit combines two pieces of data input in a data period in each reference period twice the data period and outputs the two pieces of data as double length data including higher-order data and lower-order data. The first bank has a first bank first memory and a first bank second memory to and from which write and read operations are performed in the reference period, and alternately changes to the write state and to the read state in each reference period. The second bank has a second bank first memory and a second bank second memory to and from which write and read operations are performed in the reference period, and alternately changes to the write state and to the read state in the phase opposite to that of the first bank. An output data clock transfer circuit reads double-length data stored in the first bank and the second bank in the reference period and outputs in the data period after dividing the double-length data into higher-order data and lower-order data. The control circuit controls the first bank and the second bank so that input data groups are stored sequentially in the first bank and in the second bank and the stored data groups are read sequentially.

The control circuit controls the first and second banks so that the input data groups are sequentially stored in the first bank and in the second bank in each reference period twice the data period and the stored data groups are sequentially read, and therefore, data having a data period twice the write time of the first bank and the second bank is written.

### BRIEF DESCRIPTION OF THE DRAWINGS

FIG. 1 is a circuit block diagram of an example of the data transfer device;
FIG. 2A is an internal circuit block diagram of the input data clock transfer circuit illustrated in Fig. 1;
FIG. 2B is a diagram illustrating a time chart of the input data clock transfer circuit illustrated in Fig. 1;
FIG. 3 is an internal circuit block diagram of the timing adjustment circuit illustrated in Fig. 1;
FIG. 4 is an internal circuit block diagram of the output data clock transfer circuit illustrated in Fig. 1;
FIG. 5 is an internal circuit block diagram of the control circuit illustrated in Fig. 1;
FIG. 6 is a diagram illustrating a time chart of the data transfer device illustrated in Fig. 1;
FIG. 7A is a first write state of the time chart illustrated in Fig. 6;
FIG. 7B is a second write state of the time chart illustrated in Fig. 6;
FIG. 7C is a third write state of the time chart illustrated in Fig. 6;
FIG. 7D is a forth write state of the time chart illustrated in Fig. 6;
FIG. 8 is a circuit block diagram of another example of the data transfer device;
FIG. 9 is an internal circuit block diagram of the control circuit illustrated in Fig. 8;
FIG. 10A is an internal circuit block diagram of the data information FIFO queue group;
FIG. 10B is a diagram illustrating an example of data stored in the data information FIFO queue group;
FIG. 11 is an internal circuit block diagram of the write pointer illustrated in Fig. 8;
FIG. 12 is an internal circuit block diagram of the read pointer illustrated in Fig. 8;
FIG. 13A is a diagram illustrating a time chart of the data transfer device illustrated in Fig. 8;
FIG. 13B is a first write state of the time chart illustrated in Fig. 13A;
FIG. 13C is a second write state of the time chart illustrated in Fig. 13A;
FIG. 13D is a third write state of the time chart illustrated in Fig. 13A;
FIG. 13E is a forth write state of the time chart illustrated in Fig. 13A;
FIG. 14A is a diagram illustrating an example of the data groups to be input to the data transfer device illustrated in Fig. 8;
FIG. 14B is a diagram illustrating an example of the data groups illustrated in Fig. 14A;
FIG. 14C is a diagram illustrating other example of the data groups illustrated in Fig. 14A;
FIG. 14D is a diagram illustrating another example of the data groups illustrated in Fig. 8;
FIG. 14E is a diagram illustrating an example of the data groups illustrated in Fig. 14D;
FIG. 14F is a diagram illustrating other example of the data groups illustrated in Fig. 14D;
FIG. 15A is an example of a time charts of the data transfer device illustrated in Fig 8;
FIG. 15B is an example of a time charts of the data transfer device illustrated in Fig 8;
FIG. 16A is another example of a time charts of the data transfer device illustrated in Fig 8; and
FIG. 16B is another example of a time charts of the data transfer device illustrated in Fig 8.

### DESCRIPTION OF EMBODIMENTS

Hereinafter, with reference to the drawings, a data transfer device according to the present invention is explained. However, the technical scope of the present invention is not limited to embodiments and it should be noted that the technical scope also includes equivalents to the inventions described in the claims.

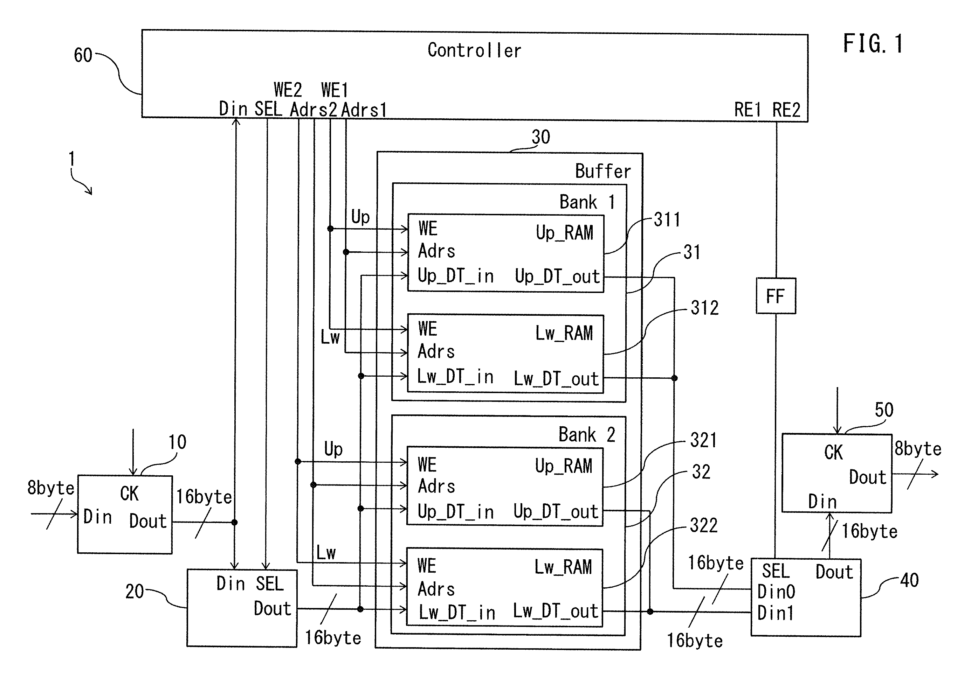

Fig. 1 is a circuit block diagram of an example of the data transfer device.

A data transfer device 1 has an input data clock transfer circuit 10, a timing adjustment circuit 20, a buffer 30, an output selection circuit 40, an output data clock transfer circuit 50, and a control circuit 60.

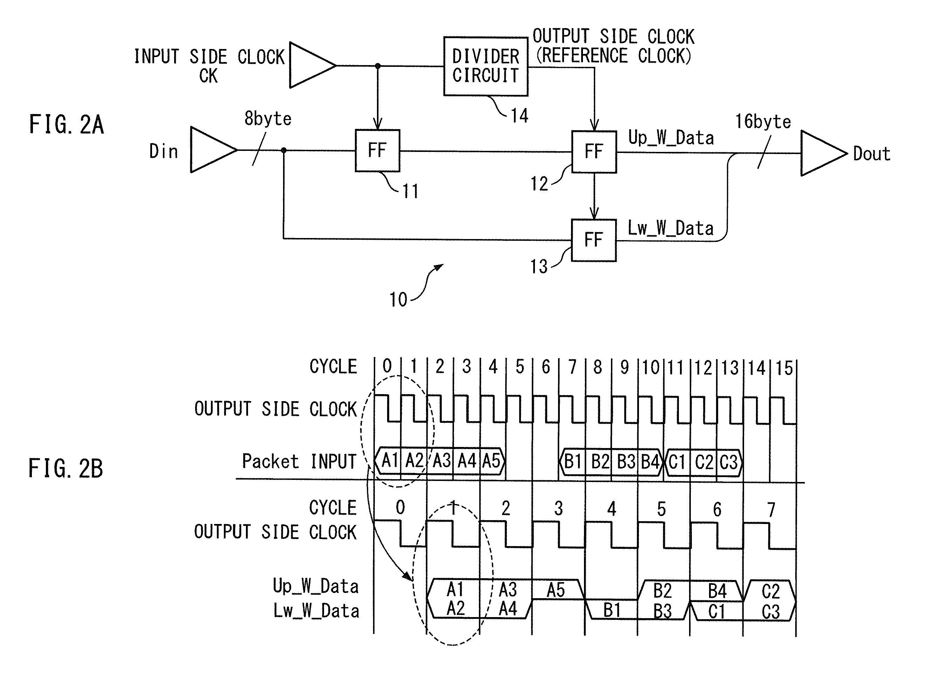

Fig. 2A is an internal circuit block diagram of the input data clock transfer circuit 10 and Fig. 2B is a diagram illustrating a time chart of the input data clock transfer circuit 10.

The input data clock transfer circuit 10 has a first latch circuit 11, a second latch circuit 12, a third latch circuit 13, and a divider circuit 14. Each of the first to third latch circuits 11 to 13 latches data having a data bus width of eight bytes and outputs the latched data in accordance with a clock signal that is input. An input side clock signal in accordance with the clock period of input data is input to the divider circuit 14 and the divider circuit 14 outputs the input side clock signal as an output side clock signal whose period is twice the period of the input clock signal. The output side clock signal is provided to the timing adjustment circuit 20 and the control circuit 60 via a wire, not illustrated, and is used as the reference clock in the timing adjustment circuit 20 and the control circuit 60. In other words, the period of the clock signal used in the timing adjustment circuit 20 and the control circuit 60 is a period twice the period of the clock of the input data. In the present specification, the period twice that of the clock of input data is referred to as the reference period.

The first latch circuit 11 latches input data having a data bus width of eight bytes by an input side clock signal, and outputs the latched data in accordance with the input side clock signal. The second latch circuit 12 outputs the data having a data bus width of eight bytes output from the first latch circuit 11 as higher-order data Up_W_Data in accordance with the output side clock signal whose period is twice that of the input side clock signal. The third latch circuit 13 outputs the input data having a data bus width of eight bytes as lower-order data Lw_W_Data in accordance with the output side clock signal having the period twice that of the input side clock signal.

The input data clock transfer circuit 10 outputs input data having a data bus width of eight bytes as output data having a data bus width of 16 bytes at a data rate half the data rate of the input data.

In the example illustrated in Fig. 2B, data latched in even-numbered periods of the input side clock is output as the higher-order data Up_W_Data and data latched in odd-numbered periods of the input side clock is output as the lower-order data Lw_W_Data.

First data A1 of a first data group of A1 to A5 is output as the higher-order data Up_W_Data and the second data A2 is output as the lower-order data Lw_W_Data. Then, the last data A5 of the first data group of A1 to A5 is output as the higher-order data Up_W_Data.

On the other hand, first data B1 of a second data group of B1 to B4 and first data C1 of a third data group of C1 to C3 are output as the lower-order data Lw_W_Data, respectively, and the second data B2 and C2 are output as the higher-order data Up_W_Data, respectively, since while the first data A1 of the first data group arrives in cycle 0, which is an even-numbered cycle, the first data B1 and C1 of the second data group and the third data group arrive in cycles 7 and 11, which are odd-numbered cycles, respectively.

The input data clock transfer circuit 10 combines two pieces of data input in the data period in each reference period twice the data period and outputs the two pieces of data as double length data including the higher-order data Up_W_Data and the lower-order data Lw_W_Data.

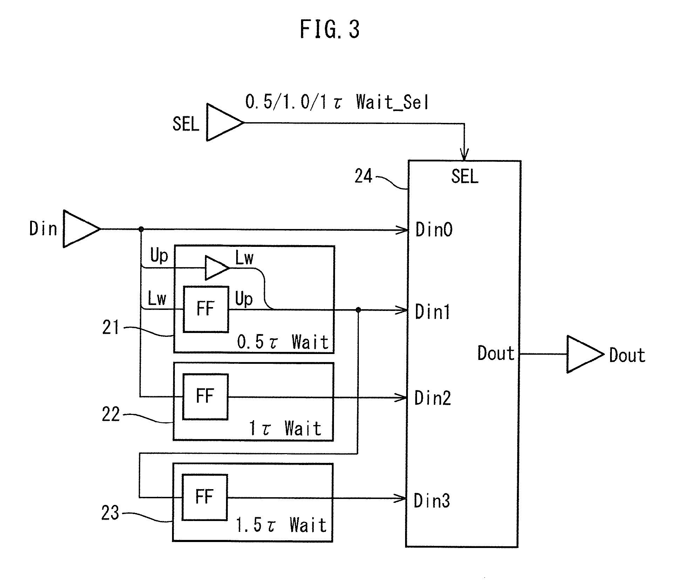

Fig. 3 is an internal circuit block diagram of the timing adjustment circuit 20.

The timing adjustment circuit 20 has a first delay circuit 21, a second delay circuit 22, a third delay circuit 23, and a delay selection circuit 24.

The first delay circuit 21 turns the input higher-order data Up_W_Data into the lower-order data Lw_W_Data and at the same time, delays the input lower-order data Lw_W_Data by a time corresponding to one cycle of the reference period and outputs as the higher-order data Up_W_Data. Data output from the first delay circuit 21 is input to a second input terminal Din1 of the delay selection circuit 24 as first delay data. The second delay circuit 22 outputs the higher-order data Up_W_Data and the lower-order data Lw_W_Data that are input after delaying them by a time corresponding to one cycle of the reference period, respectively. Data output from the second delay circuit 22 is input to a third input terminal Din2 of the delay selection circuit 24 as second delay data. The third delay circuit 23 outputs the higher-order data Up_W_Data and the lower-order data Lw_W_Data that are output from the first delay circuit 21 after further delaying them by a time corresponding to one cycle of the reference period, respectively. Data output from the third delay circuit 23 is input to a fourth input terminal Din3 of the delay selection circuit 24 as third delay data. The lower-order data Lw_W_Data of the third delay data is the input higher-order data Up_W_Data delayed by a time corresponding to one cycle of the reference period. The higher-order data Up_W_Data of the third delay data is the input lower-order data Lw_W_Data delayed by a time corresponding to two cycles of the reference period.

Data output from the input data clock transfer circuit 10 is input to a first input terminal Din0 of the delay selection circuit 24. The first delay data output from the first delay circuit 21 is input to the second input terminal Din1 of the delay selection circuit 24. The second delay data output from the second delay circuit 22 is input to the third input terminal Din2 of the delay selection circuit 24. The third delay data output from the third delay circuit 23 is input to the fourth input terminal Din3 of the delay selection circuit 24. The delay selection circuit 24 outputs any one of the data input to the first input terminal Din0, the second input terminal Din1, the third input terminal Din2, and the fourth input terminal Din3, based on the delay selection signal input from the control circuit 60 from an output terminal Dout.

The buffer 30 has a first bank 31 and a second bank 32. The first bank 31 has a first bank first memory 311 and a first bank second memory 312. The second bank 32 has a second bank first memory 321 and a second bank second memory 322.

The first bank first memory 311, the first bank second memory 312, the second bank first memory 321, and the second bank second memory 322 are each a RAM capable of storing input data having a data bus width of eight bytes.

The first bank first memory 311 writes the higher-order data Up_W_Data output from the timing adjustment circuit 20 in an address specified by an address input terminal Adrs when a write enable signal is input to a write enable terminal WE. The first bank second memory 312 writes the lower-order data Lw_W_Data output from the timing adjustment circuit 20 in an address specified by the address input terminal Adrs when the write enable signal is input to the write enable terminal WE. The second bank first memory 321 writes the higher-order data Up_W_Data output from the timing adjustment circuit 20 in an address specified by the address input terminal Adrs when the write enable signal is input to the write enable terminal WE. The second bank second memory 322 writes the lower-order data Lw_W_Data output from the timing adjustment circuit 20 in an address specified by the address input terminal Adrs when the write enable signal is input to the write enable terminal WE.

Data continuation signals Data_Write_Enable_Up and Data_Write_Enable_Lw are input to the write enable terminals WE of the first bank first memory 311 and the first bank second memory 312, respectively. The inverted signals of the signals input to the write enable terminals WE of the first bank first memory 311 and the first bank second memory 312 are input to the write enable terminals WE of the second bank first memory 321 and the second bank second memory 322. Since the inverted signals are input to the write enable terminals WE of the memories arranged in the second bank 32, write to the memories arranged in the second bank 32 is disable when write to the memories arranged in the first bank 31 is enable. Further, when write to the memories arranged in the first bank 31 is disable, write to the memories arranged in the second bank 32 is enable.

Each of the first bank first memory 311 and the second bank first memory 321 reads the data stored in the address specified by the address input terminal Adrs as higher-order data Up_R_Data. Each of the first bank second memory 312 and the second bank second memory 322 reads the data stored in the address specified by the address input terminal Adrs as lower-order data Lw_R_Data.

The first bank 31 has the first bank first memory 311 and the first bank second memory 312 to and from which write and read operations are performed in the reference period, and alternately changes to the write state and to the read state in each reference period. The second bank 32 has the second bank first memory 321 and the second bank second memory 322 to and from which write and read operations are performed in the reference period, and alternately changes to the write state and to the read state in the phase opposite to that of the first bank 31.

The output selection circuit 40 outputs one of the data input to the first data input terminal Din0 and the data input to the second data input terminal Din1, based on the signal input to an output selection terminal SEL. Data output from the first bank first memory 311 and the first bank second memory 312 is input to the first data input terminal Din0. Data output from the second bank first memory 321 and the second bank second memory 322 is input to the second data input terminal Din1.

Signals obtained by buffering output signals form a first read enable terminal RE1 and a second read enable terminal RE2 of the control circuit 60 are input to the output selection terminal SEL of the output selection circuit 40. The output selection circuit 40 selects data that is read when the memory arranged in the first bank 31 is write disable. Further, the output selection circuit 40 selects data that is read from the memory arranged in the second bank 32 when the memory arranged in the first bank 31 is write enable. When the memory arranged in the first bank 31 is write enable, the memory arranged in the second bank 32 is write disable. Thus, the output selection circuit 40 selects data that is read when the memory arranged in the second bank 32 is write disable. The output selection circuit 40 reads data stored in both or one of the first bank first memory 311 and the first bank second memory 312, based on read enable signals Data_Read_Enable_Up/Lw. The output selection circuit 40 reads data stored in both the first bank first memory 311 and the first bank second memory 312 when both the read enable signals Data_Read_Enable_Up/Lw are 1 and the first bank 31 is selected. The output selection circuit 40 reads data stored in the first bank first memory 311 when only the read enable signal Data_Read_Enable_Up is 1 and the first bank 31 is selected. The output selection circuit 40 reads data stored in the first bank second memory 312 when only the read enable signal Data_Read_Enable_Lw is 1 and the first bank 31 is selected. The output selection circuit 40 reads data stored in both or one of the second bank first memory 321 and the second bank second memory 322, based on the read enable signals Data_Read_Enable_Up/Lw. The output selection circuit 40 reads data stored in both the second bank first memory 321 and the second bank second memory 322 when both the read enable signals Data_Read_Enable_Up/Lw are 1 and the second bank 32 is selected. The output selection circuit 40 reads data stored in the second bank first memory 321 when only the read enable signal Data_Read_Enable_Up is 1 and the second bank 32 is selected. The output selection circuit 40 reads data stored in the second bank second memory 322 when only the read enable signal Data_Read_Enable_Lw is 1 and the memory arranged in the second bank 32 is write enable.

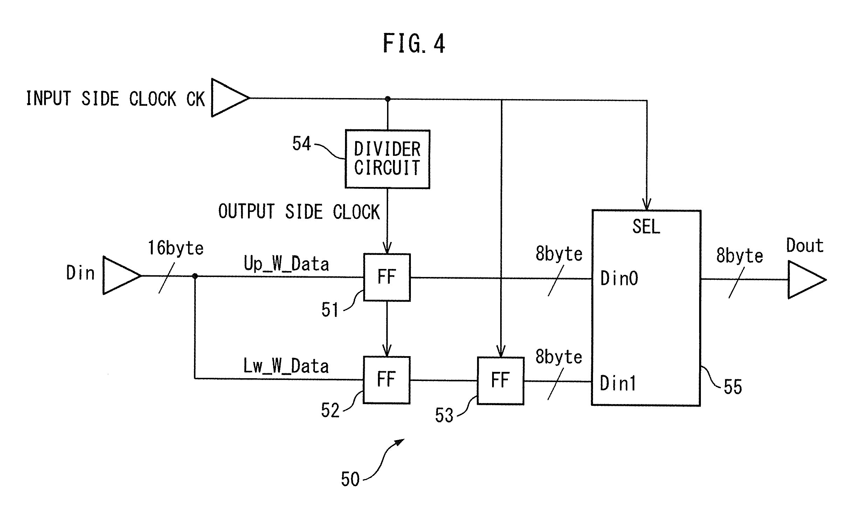

Fig. 4 is an internal circuit block diagram of the output data clock transfer circuit 50.

The output data clock transfer circuit 50 has a first latch circuit 51, a second latch circuit 52, a third latch circuit 53, a divider circuit 54, and an output data selection circuit 55. Each of the first to third latch circuits 51 to 53 latches data having a data bus width of eight bytes and outputs the latched data in accordance with a clock signal that is input. an input side clock signal in accordance with the clock period of input data is input to the divider circuit 54, and the divider circuit 54 outputs a clock signal having a period twice the period of the input clock signal as an output side clock signal.

The first latch circuit 51 latches the higher-order data Up_R_Data output from the output selection circuit 40 in accordance with the output side clock signal having a period twice that of the input side clock signal and outputs the data to the first data input terminal Din0 of the output data selection circuit 55. The second latch circuit 52 latches the lower-order data Lw_R_Data output from the output selection circuit 40 in accordance with an output side clock signal having a period twice that of the input side clock signal and outputs the data to the third latch circuit 53. The third latch circuit 53 latches the lower-order data Lw_R_Data output from the second latch circuit 52 in accordance with the input side clock signal and outputs the data to the second data input terminal Din1 of the output data selection circuit 55.

The output data selection circuit 55 outputs the data input to the first data input terminal Din0 and to the second data input terminal Din1 alternately in each one cycle of the input side clock signal in accordance with the input side clock signal input to the selection terminal SEL. The output data selection circuit 55 sequentially outputs the data stored in the first bank first memory 311, the first bank second memory 312, the second bank first memory 321, and the second bank second memory 322 in a period half the reference period.

The output data clock transfer circuit 50 reads the double length data stored in the first bank first memory 311, the first bank second memory 312, the second bank first memory 321, and the second bank second memory 322 in the reference period and outputs the data in the data period after dividing the data into higher-order data and lower-order data.

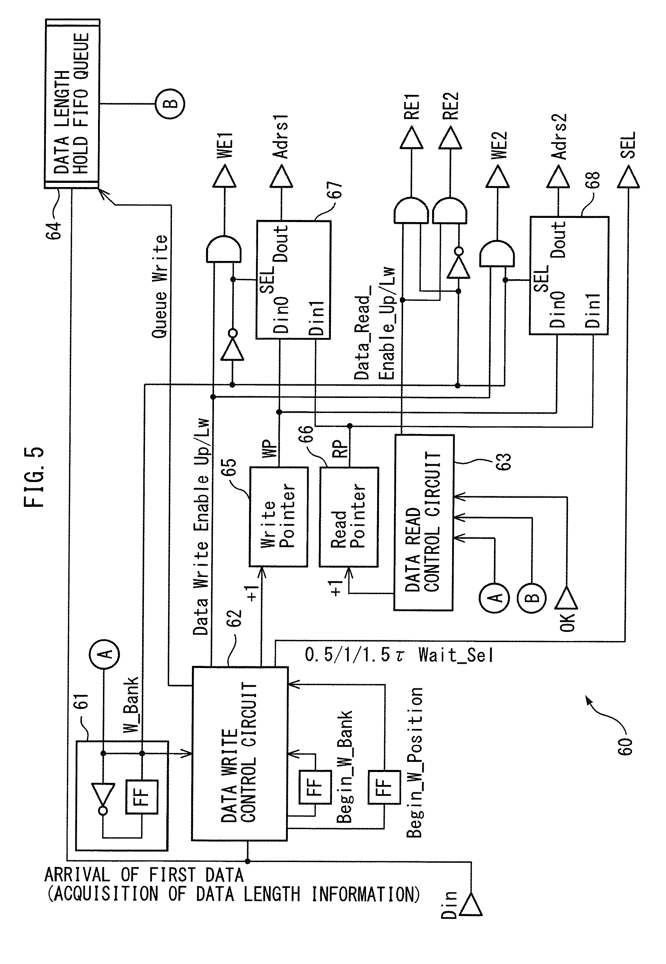

Fig. 5 is an internal circuit block diagram of the control circuit 60.

The control circuit 60 has a write bank switching switch 61, a write control circuit 62, a read control circuit 63, a data length hold FIFO queue 64, a write pointer 65, and a read pointer 66. The control circuit 60 further has a first bank address selection circuit 67 and a second bank address selection circuit 68.

The write bank switching switch 61 performs the toggle operation and sequentially outputs 0 and 1 in each cycle of the reference period. In the cycle during which the write bank switching switch 61 outputs 0, the first bank 31 is selected as a write bank and in the cycle during which the write bank switching switch 61 outputs 1, the second bank 32 is selected as a write bank.

Data from the input data clock transfer circuit 10 and the signal from the write bank switching switch 61 are input to the write control circuit 62. The write control circuit 62 determines the data length of a data group that is input, based on the data from the input data clock transfer circuit 10 and outputs data length information corresponding to the data length to the data length hold FIFO queue 64. For example, when the data group that is input is an IP packet, the write control circuit 62 reads an IP header and determines the data length.

While the data group is being written to the buffer 30, the write control circuit 62 determines whether data is written to the second bank second memory. When determining that data is written to the second bank second memory, the write control circuit 62 outputs an increment signal to the write pointer 65.

The write control circuit 62 determines the bank and the memory to which the last data of the data group is written, based on the bank and the memory to which the first data of the data group is written and the determined data length of the data group. Then, the write control circuit 62 determines the bank and the memory to which the first data of the data group that will arrive next is written.

When it is determined that the last data of the data group is written to the first bank first memory 311, it is determined that the first data of the next data group is written to the first bank second memory 312. At this time, a first data write bank signal Begin_W_Bank indicates the first bank and a first data write memory signal Begin_W_Position indicates the second memory. When it is determined that the last data of the data group is written to the first bank second memory 312, it is determined that the first data of the next data group is written to the second bank first memory 321. At this time, the first data write bank signal Begin_W_Bank indicates the second bank and the first data write memory signal Begin_W_Position indicates the first memory.

When it is determined that the last data of the data group is written to the second bank first memory 321, it is determined that the first data of the next data group is written to the second bank second memory 322. At this time, the first data write bank signal Begin_W_Bank indicates the second bank and the first data write memory signal Begin_W_Position indicates the second memory. When it is determined that the last data of the data group is written to the second bank second memory 322, it is determined that the first data of the next data group is written to the first bank first memory 311. At this time, the first data write bank signal Begin_W_Bank indicates the first bank and the first data write memory signal Begin_W_Position indicates the first memory.

The write control circuit 62 stores the first data write bank signal Begin_W_Bank indicating which of the first bank and the second bank is the bank to which the first data of the data group that will arrive next is written. Further, the write control circuit 62 stores the first data write memory signal Begin_W_Position indicating which of the first memory and the second memory is the memory to which the first data of the data group that will arrive next is written.

When the first data of the data group that arrives next is input, the write control circuit 62 compares the output signal of the write bank switching switch 61 and the first data write bank signal Begin_W_Bank. When the bank selected by the output signal of the write bank switching switch 61 is consistent with the bank indicated by the first data write bank signal Begin_W_Bank, the write control circuit 62 generates and stores a bank consistency signal. When the bank selected by the output signal of the write bank switching switch 61 and the bank indicated by the first data write bank signal Begin_W_Bank are not consistent with each other, the write control circuit 62 generates and stores a bank inconsistency signal.

Next, the write control circuit 62 compares the data position of the first data allocated by the input data clock transfer circuit 10 and the first data write memory signal Begin_W_Position. When the position of the first data allocated by the input data clock transfer circuit 10 is the higher-order data and the memory indicated by the first data write memory signal Begin_W_Position is the first memory, the write control circuit 62 determines that both are consistent with each other. Further, when the position of the first data allocated by the input data clock transfer circuit 10 is the lower-order data and the memory indicated by the first data write memory signal Begin_W_Position is the second memory, the write control circuit 62 determines that both are consistent with each other. On the other hand, when the position of the first data allocated by the input data clock transfer circuit 10 is the higher-order data and the memory indicated by the first data write memory signal Begin_W_Position is the second memory, the write control circuit 62 determines that both are not consistent with each other. Further, when the position of the first data allocated by the input data clock transfer circuit 10 is the lower-order data and the memory indicated by the first data write memory signal Begin_W_Position is the first memory, the write control circuit 62 determines that both are not consistent with each other.

When the data position of the first data allocated by the input data clock transfer circuit 10 and the memory indicated by the first data write memory signal Begin_W_Position are consistent with each other, the write control circuit 62 generates and stores a memory consistency signal. When the data position of the first data allocated by the input data clock transfer circuit 10 and the memory indicated by the first data write memory signal Begin_W_Position are not consistent with each other, the write control circuit 62 generates and stores a memory inconsistency signal.

The write control circuit 62 outputs a timing selection signal to the timing adjustment circuit 20 and adds an appropriate delay time to data output from the input data clock transfer circuit 10. By the write control circuit 62 adding an appropriate delay time to the data output from the input data clock transfer circuit 10, the input data group stands by until the bank and the memory to which the first data of the data group can be written is reached.

The write control circuit 62 calculates the write period of time, which is the period of time during which the input data group is written, from the data length of the data group and the data position of the first data of the data group to be written. When the first data of the data group to be written is allocated to the higher-order data Up_W_Data and the data length of the data group is an even number, the write period of time is the number of cycles corresponding to half the data length. Further, when the first data of the data group to be written is allocated to the lower-order data Lw_W_Data and the data length of the data group is an even number, the write period of time is the number of cycles corresponding to a value of half the data length to which 1 is added. When the data length of the data group is an odd number, regardless of whether the first data of the data group is allocated to the higher-order data Up_W_Data or to the lower-order data Lw_W_Data, the write period of time is the number of cycles corresponding to a value of half the data length to which 1 is added. For example, when the first data of the data group to be written is allocated to the higher-order data Up_W_Data and the data length is eight, the write period of time is a period of time corresponding to four cycles of the reference period. When the first data of the data group to be written is allocated to the lower-order data Lw_W_Data and the data length is eight, the write period of time is a period of time corresponding to five cycles of the reference period. When the data length is 11, the write period of time is a period of time corresponding to six cycles of the reference period.

When the write control circuit 62 stores the bank consistency signal and the memory consistency signal, the write control circuit 62 outputs the timing selection signal during the write period of time so that the timing adjustment circuit 20 outputs data that is input to the first input terminal. Further, the write control circuit 62 outputs the data continuation signals Data_Write_Enable_Up/Lw throughout the period of time corresponding to the calculated write period of time.

When the write control circuit 62 stores the bank consistency signal and the memory inconsistency signal, the write control circuit 62 outputs the timing selection signal during the write period of time so that the timing adjustment circuit 20 outputs data that is input to the second input terminal. Further, the write control circuit 62 outputs the data continuation signals Data_Write_Enable_Up/Lw throughout the period of time corresponding to the calculated write period of time.

When the write control circuit 62 stores the bank inconsistency signal and the memory consistency signal, the write control circuit 62 stands by for a time corresponding to one cycle of the reference period. Then, the write control circuit 62 outputs the timing selection signal during the write period of time so that the timing adjustment circuit 20 outputs data that is input to the third input terminal and at the same time, outputs the data continuation signals Data_Write_Enable_Up/Lw.

When the write control circuit 62 stores the bank inconsistency signal and the memory inconsistency signal, the write control circuit 62 stands by for a time corresponding to two cycle of the reference period. Then, the write control circuit 62 outputs the timing selection signal during the write period of time so that the timing adjustment circuit 20 outputs data that is input to the fourth input terminal and at the same time, outputs the data continuation signals Data_Write_Enable_Up/Lw.

When a data presence signal is input from the data length hold FIFO queue 64 and a read OK signal OK enters the read enable state, the read control circuit 63 starts read control. As a read enable signal RE, 1 indicative of the disable state is input when the output destination is busy and 0 indicative of the enable state is input when the output destination is not busy.

The read control circuit 63 determines the bank, the memory, and the address of the first data of the data group to be read, based on the bank and the memory in which the last data of the data group stored immediately before is stored. When the last data of the data group stored immediately before is stored in the first bank first memory 311, it is determined that the first data of the data group to be read is stored in the same address of the first bank second memory 312. When the last data of the data group stored immediately before is stored in the first bank second memory 312, it is determined that the first data of the data group to be read is stored in the same address of the second bank first memory 321. When the last data of the data group stored immediately before is stored in the second bank first memory 321, it is determined that the first data of the data group to be read is stored in the same address of the second bank second memory 322. When the last data of the data group stored immediately before is stored in the second bank second memory 322, it is determined that the first data of the data group to be read is stored in the next address of the first bank first memory 311.

Next, the read control circuit 63 determines whether the bank in which the first data of the data group to be read is stored is selected as the write bank, based on the output signal of the write bank switching switch 61. When it is determined that the bank in which the first data of the data group to be read is stored is selected as the write bank, the read control circuit 63 starts read after standing by for one cycle of the reference period. When it is determined that the bank in which the first data of the data group to be read is stored is not selected as the write bank, the read control circuit 63 starts read. When the read enable signals Data_Read_Enable_Up/Lw are 1 and the second bank 32 is selected as the write bank, the signal output from the first read enable terminal RE1 is 1. In other words, when the read enable signal Data_Read_Enable_Up is 1 and the second bank 32 is selected as the write bank, the signal output from the first read enable terminal RE1 (Up) is 1. Further, when the read enable signal Data_Read_Enable_Lw is 1 and the second bank 32 is selected as the write bank, the signal output from the first read enable terminal RE1 (Lw) is 1. When the read enable signals Data_Read_Enable_Up/Lw are 1 and the first bank 31 is selected as the write bank, the signal output from the second read enable terminal RE2 is 1. In other words, when the read enable signal Data_Read_Enable_Up is 1 and the first bank 31 is selected as the write bank, the signal output from the second read enable terminal RE2 (Up) is 1. Further, when the read enable signal Data_Read_Enable_Lw is 1 and the first bank 31 is selected as the write bank, the signal output from the second read enable terminal RE2 (Lw) is 1.

While the data group stored in the buffer 30 is being read, the read control circuit 63 determines whether data is read to the second bank second memory 322. When determining that data is read to the second bank second memory 322, the write control circuit 62 outputs the increment signal to the read pointer 66.

The read control circuit 63 calculates the read period of time, which is the period of time during which the data group stored in the buffer 30 is read, based on the data length information of the data group stored in the data length hold FIFO queue 64. When the read period of time ends, the read control circuit 63 ends the read. When the read ends, the read control circuit 63 stores the bank and the memory in which the last data is stored.

The data length hold FIFO queue 64 sequentially stores data length information indicative of the data length of the data group determined by the write control circuit 62. The write point 65 increments the write address when the increment signal is input from the write control circuit 62. The read pointer 66 increments the read address when the increment signal is input from the read control circuit 63. The write pointer 65 and the read pointer 66 wrap around the first address after the write address and the read address have reached the maximum address.

The first bank address selection circuit 67 selects one of the write address output from the write pointer 65 and the read address output from the read pointer 66, based on the signal output from the write bank switching switch 61. When the write bank switching switch 61 outputs 0 and selects the first bank 31 as the write bank, the first bank address selection circuit 67 outputs the write address output from the write pointer 65. When the write bank switching switch 61 outputs 1 and selects the second bank 32 as the write bank, the first bank address selection circuit 67 outputs the read address output from the read pointer 66.

The second bank address selection circuit 68 selects one of the write address output from the write pointer 65 and the read address output from the read pointer 66, based on the signal output from the write bank switching switch 61. When the write bank switching switch 61 outputs 0 and selects the first bank 31 as the write bank, the second bank address selection circuit 68 outputs the read address output from the read pointer 66. When the write bank switching switch 61 outputs 1 and selects the second bank 32 as the write bank, the second bank address selection circuit 68 outputs the write address output from the write pointer 65.

The control circuit 60 sequentially stores the data groups input to the input data clock transfer circuit 10 in the first bank 31 and the second bank 32 and controls the first bank 31 and the second bank 32 so as to read the stored data groups in order and to output the data groups from the output data clock transfer circuit 50. The control circuit 60 writes the data groups in order from the position following the storage position of the last data of the data group stored immediately before in the first bank 31 and the second bank 32.

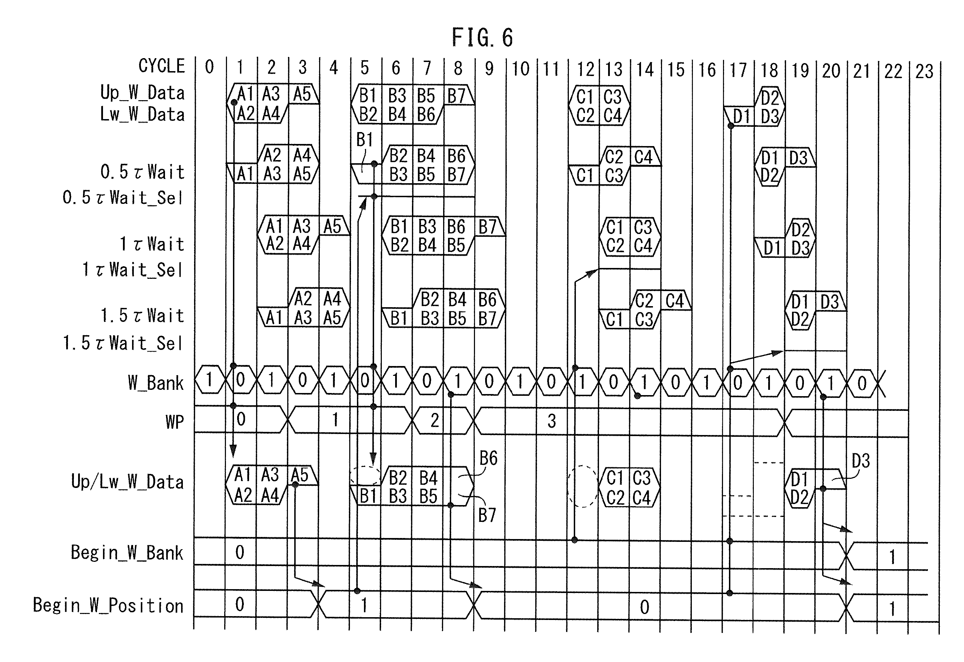

Fig. 6 is a diagram illustrating a time chart of the data transfer device 1. In Fig. 6, one cycle corresponds to the reference period and "Up/Lw_Data" indicates data output from the input data clock transfer circuit 10. "0.5τWait" indicates the first delay data output from the first delay circuit 21 and the straight line of "0.5τWait_Sel" indicates that a signal indicative of that the first delay data output from the first delay circuit 21 will be selected is output as a timing selection signal. "1τWait" indicates the second delay data output from the second delay circuit 22 and the straight line of "1τWait_Sel" indicates that a signal indicative of that the second delay data output from the second delay circuit 22 will be selected is output as a timing selection signal. "1.5τWait" indicates the third delay data output from the third delay circuit 23 and the straight line of "1.5τWait_Sel" indicates that a signal indicative of that the third delay data output from the third delay circuit 23 will be selected is output as a timing selection signal. "W_Bank" indicates data output from the write bank switching switch 61 and "Wp" indicates write address data output from the write pointer 65. "Up/Lw_W_Data" indicates data to be written to the buffer 30 and "Begin_W_Bank" indicates the first data write bank signal output from the write control circuit 62. "Begin_W_Position" indicates the first data write memory signal output from the write control circuit 62.

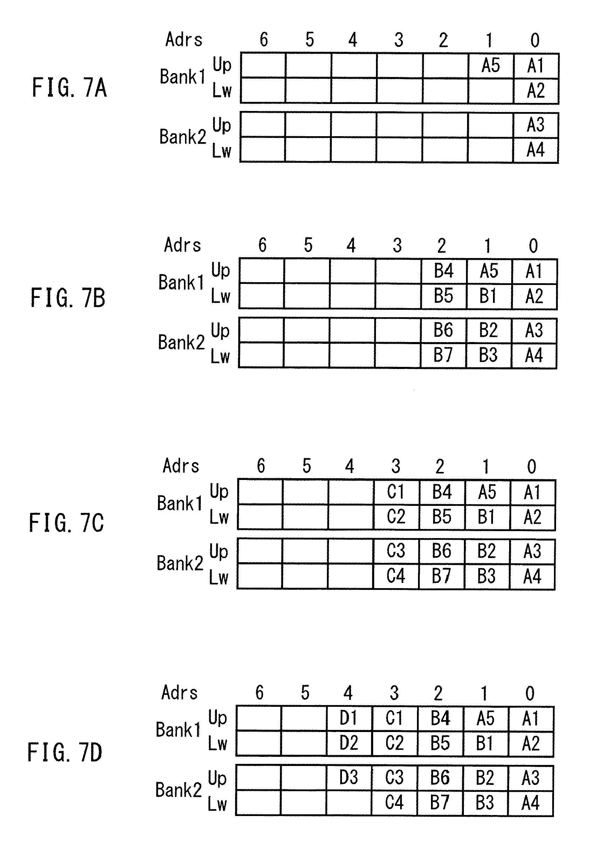

Figs. 7A to 7D are diagrams each illustrating the bank and the memory to which the data illustrated in Fig. 6 is written. In Figs. 7A to 7D, "Up" and "Lw" of "Bank1" indicate the first bank first memory 311 and the first bank second memory 312, respectively. "Up" and "Lw" of "Bank2" indicate the second bank first memory 321 and the second bank second memory 322, respectively.

In the time chart illustrated in Fig. 6, to the data transfer device 1, the first data group of A1 to A5, a second data group of B1 to B7, a third data group of C1 to C4, and a fourth data group of D1 to D3 are input.

In cycle 1, the first data A1 and the second data A2 of the first data group of A1 to A5 are output from the input data clock transfer circuit 10. When the first data A1 of the first data group of A1 to A5 is input, the write control circuit 62 determines the data length of the first data group of A1 to A5 to be 5, based on information stored in the first data A1.

In cycle 1, the data transfer device has no stored data. Thus, the first data write bank signal Begin_W_Bank is 0 indicative of the first bank and the first data write memory signal Begin_W_Position is 0 indicative of the first memory. In cycle 1, "W_Bank" is 0 and is consistent with the first data write bank signal "Begin_W_Bank", and therefore the write control circuit 62 generates and stores a bank consistency signal. Further, the memory position of the first data A1 is the first memory and the first data write memory signal Begin_W_Position indicates the first memory, and therefore the write control circuit 62 generates and stores a memory consistency signal. Since the write control circuit 62 stores the bank consistency signal and the memory consistency signal, a timing selection signal is output so that the timing adjustment circuit 20 outputs data input to the first input terminal Din0. Since a timing selection signal is output so that the timing adjustment circuit 20 outputs data input to the first input terminal Din0, data output from the input data clock transfer circuit 10 is written. The write control circuit 62 calculates the write period of time as three cycles.

As illustrated in Fig. 7A, the first data A1 of the first data group of A1 to A5 is written in address 0 of the first bank first memory 311 of the first bank 31 and the second data A2 is written in address 0 of the first bank second memory 312 of the first bank 31. The third data A3 of the first data group of A1 to A5 is written in address 0 of the second bank first memory 321 of the second bank 32 and the fourth data A4 is written in address 0 of the second bank second memory 322 of the second bank 32. The last data A5 of the first data group of A1 to A5 is written in address 1 of the first bank first memory 311 of the first bank 31.

In cycle 5, the first data B1 and the second data B2 of the second data group of B1 to B7 are output from the input data clock transfer circuit 10. When the first data B1 of the second data group of B1 to B7 is input, the write control circuit 62 determines the data length of the second data group of B1 to B7 to be 7, based on information stored in the first data B1.

Since the last data A5 of the first data group of A1 to A5 is stored in address 1 of the first bank first memory 311 of the first bank 31, the first data of the second data group of B1 to B7 is written in address 1 of the first bank second memory 312 of the first bank 31 as a result. Thus, the first data write bank signal Begin_W_Bank indicates 0 corresponding to the first bank and the first data write memory signal Begin_W_Position indicates 1 corresponding to the second memory. In cycle 5, "W_Bank" is 0 and is in consistency with the first data write bank signal Begin_W_Bank, and therefore the write control circuit 62 generates and stores the bank consistency signal. Although the memory position of the first data B1 is the first memory, the first data write memory signal Begin_W_Position indicates the second memory, and therefore the write control circuit 62 generates and stores a memory inconsistency signal. Since the write control circuit 62 stores the bank consistency signal and the memory inconsistency signal, a timing selection signal is output so that the timing adjustment circuit 20 outputs data input to the second input terminal Din1. Because, the timing selection signal is output so that the timing adjustment circuit 20 outputs data input to the second input terminal Din1, to the buffer 30, the first delay data indicated by "0.5τWait" is written. The write control circuit 62 calculates the write period of time as four cycles.

As illustrated in Fig. 7B, the first data B1 of the second data group of B1 to B7 is written in address 1 of the first bank second memory 312 of the first bank 31 and the second data B2 is written in address 1 of the second bank first memory 321 of the second bank 32. The last data B7 of the second data group of B1 to B7 is written in address 2 of the second bank second memory 322 of the second bank 32.

In cycle 12, the first data C1 and the second data C2 of the third data group of C1 to C4 are output from the data transfer device 1. When the first data C1 of the third data group of C1 to C4 is input, the write control circuit 62 determines the data length of the third data group of C1 to C4 to be 4, based on information stored in the first data C1.

Since the last data B7 of the second data group of B1 to B7 is stored in address 2 of the second bank second memory 322 of the second bank 32, the first data of the third data group of C1 to C4 is written in address 3 of the first bank first memory 311 of the first bank 31 as a result. Thus, the first data write bank signal Begin_W_Bank indicates 0 corresponding to the first bank and the first data write memory signal Begin_W_Position indicates 0 corresponding to the first memory. In cycle 12, "W_Bank" is 1 and is not consistent with the first data write bank signal Begin_W_Bank, and therefore the write control circuit 62 generates and stores a bank inconsistency signal. Since the memory position of the first data C1 is the first memory and the first data write memory signal Begin_W_Position indicates the first memory, and therefore the write control circuit 62 generates and stores the memory consistency signal. Since the write control circuit 62 stores the bank inconsistency signal and the memory consistency signal, a timing selection signal is output so that the timing adjustment circuit 20 outputs data input to the third input terminal Din2. Since the timing selection signal is output so that the timing adjustment circuit 20 outputs data input to the third input terminal Din2, to the buffer 30, the second delay data indicated by "1τWait" is written. The write control circuit 62 calculates the write period of time as two cycles.

As illustrated in Fig. 7C, the first data C1 of the third data group of C1 to C4 is written in address 3 of the first bank first memory 311 of the first bank 31 and the second data C2 is written in address 3 of the first bank second memory 312 of the first bank 31. The last data C4 of the third data group of C1 to C4 is written in address 3 of the second bank second memory 322 of the second bank 32.

In cycle 17, the first data D1 of the fourth data group of D1 to D4 is output from the data transfer device 1. When the first data D1 of the fourth data group of D1 to D3 is input, the write control circuit 62 determines the data length of the fourth data group of D1 to D3 to be 3, based on information stored in the first data D1.

Since the last data C4 of the third data group of C1 to C4 is stored in address 3 of the second bank second memory 322 of the second bank 32, the first data of the fourth data group of D1 to D3 is written in address 4 of the first bank first memory 311 of the first bank 31 as a result. Thus, the first data write bank signal Begin_W_Bank indicates 0 corresponding to the first bank and the first data write memory signal Begin_W_Position indicates 0 corresponding to the first memory. In cycle 17, "W_Bank" is 1 and is not consistent with the first data write bank signal Begin_W_Bank, and therefore the write control circuit 62 generates and stores the bank inconsistency signal. Since the memory position of the first data C1 is the second memory and the first data write memory signal Begin_W_Position is 0 indicative of the first memory, and therefore the write control circuit 62 generates and stores the memory inconsistency signal. Since the write control circuit 62 stores the bank inconsistency signal and the memory inconsistency signal, a timing selection signal is output so that the timing adjustment circuit 20 outputs data input to the fourth input terminal Din3. Since the timing selection signal is output so that the timing adjustment circuit 20 outputs data input to the fourth input terminal Din3, to the buffer 30, the third delay data indicated by "1.5τWait" is written. The write control circuit 62 calculates the write period of time as two cycles.

As illustrated in Fig. 7D, the first data D1 of the fourth data group of D1 to D3 is written in address 4 of the first bank first memory 311 of the first bank 31 and the second data D2 is written in address 4 of the first bank second memory 312 of the first bank 31. The last data D3 of the fourth data group of D1 to D3 is written in address 4 of the second bank first memory 321 of the second bank 32.

In the data transfer device 1, in the order of the first bank first memory 311, the first bank second memory 312, the second bank first memory 321, and the second bank second memory 322, data that is input is stored sequentially in the memory inside the buffer in each address. The data transfer device 1 moves to the next address after storing data in all of the four memories, and therefore it is possible to effectively use the memory region.

In the data transfer device 1, the write control circuit 62 compares data output from the input data clock transfer circuit 10 and the bank and the memory to be written to the buffer 30 next and appropriately delays the data via the timing adjustment circuit 20. Thus, the data transfer device 1 has such a problem that latency performance reduces, since there is a case where the data output from the input data clock transfer circuit 10 is delayed.

Next, a data transfer device that does not bring about such a problem that latency performance reduces as in the data transfer device 1 is explained.

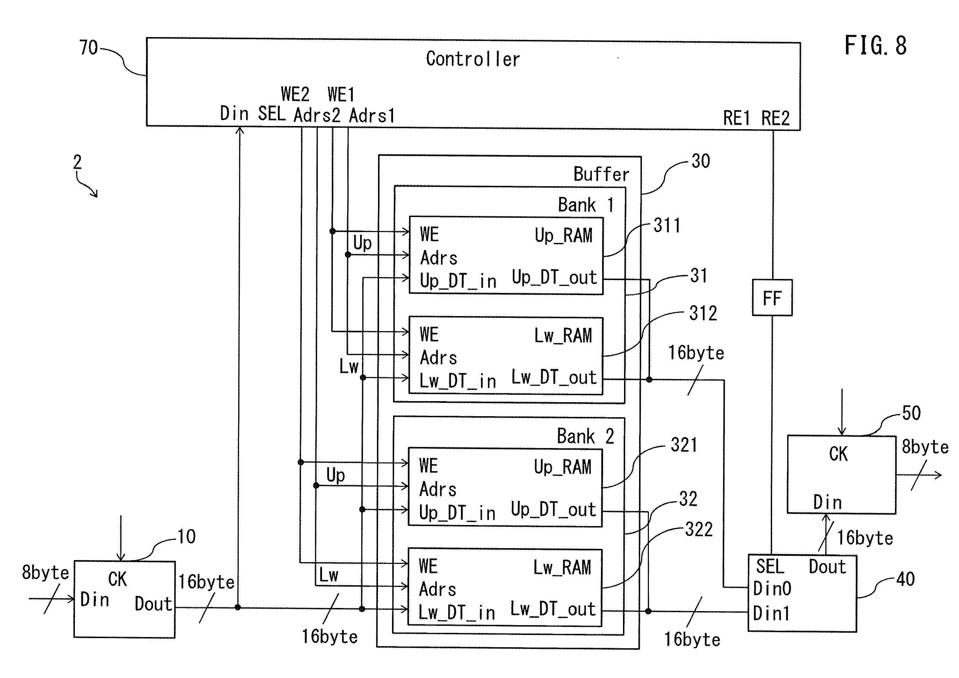

Fig. 8 is a circuit block diagram of another example of the data transfer device.

A data transfer device 2 differs from the data transfer device 1 in that the input data clock transfer circuit 10 is connected to the buffer 30 without interposition of the timing adjustment circuit 20. Further, the data transfer device 2 differs from the data transfer device 1 in that a control circuit 70 is arranged in place of the control circuit 60.

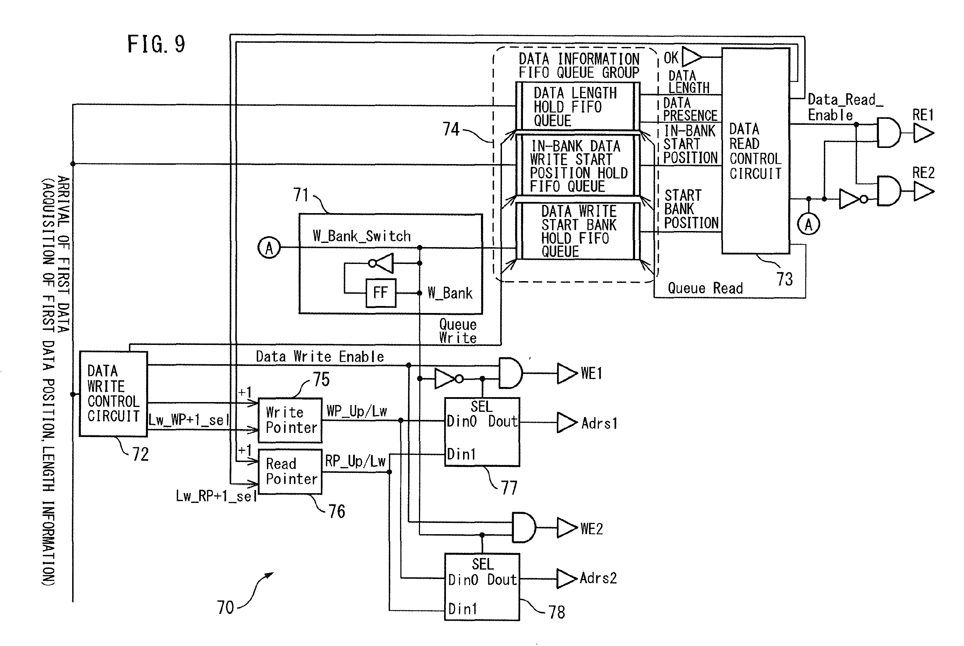

Fig. 9 is an internal circuit block diagram of the control circuit 70.

The control circuit 70 has a write bank switching switch 71, a write control circuit 72, a read control circuit 73, a data information FIFO queue group 74, a write pointer 75, and a read pointer 76. The control circuit 70 further has a first bank address selection circuit 77 and a second bank address selection circuit 78.

The write bank switching switch 71, the first bank address selection circuit 77, and the second bank address selection circuit 78 have the configurations and the functions the same as those of the write bank switching switch 61, the first bank address selection circuit 67, and the second bank address selection circuit 68, respectively.

Data from the input data clock transfer circuit 10 is input to the write control circuit 72. The write control circuit 72 calculates the write period of time, which is the period of time during which the input data group is written, from the determined data length of the data group. When the first data of the input data group is allocated to the higher-order data Up_W_Data and the data length of the data group is an even number, the write period of time is the number of cycles corresponding to half the data length. When the first data of the input data group is allocated to the lower-order data Lw_W_Data and the data length of the data group is an even number, the write period of time is the number of cycles corresponding to a value of half the data length to which 1 is added. When the data length of the data group is an odd number, regardless of whether the first data of the data group is allocated to the higher-order data Up_W_Data or to the lower-order data Lw_W_Data, the write period of time is the number of cycles corresponding to a value of half the data length to which 1 is added. The write control circuit 72 outputs the data continuation signal Data_Write_Enable throughout the period of time corresponding to the calculated write period of time.

While writing the data group to the buffer 30, the write control circuit 72 determines whether data is written to the first bank second memory 312 or to the second bank second memory 322. When determining that data is written to the second bank second memory 322 when the first data of the data group is written to the first bank 31, the write control circuit 72 outputs the increment signal to the write pointer 75. Further, when determining that data is written to the first bank second memory 312 when the first data of the data group is written to the second bank 32, the write control circuit 72 outputs the increment signal to the write pointer 75.

When data is input from the input data clock transfer circuit 10, the write control circuit 72 outputs a write start signal Queue_Write to the data information FIFO queue group 74 throughout one cycle of the reference period.

When writing the last data of the data group, the write control circuit 72 determines whether the last data of the data group is written to the first bank first memory 311 or to the second bank first memory 321. When determining that the last data of the data group is not written to the first bank first memory 311 or to the second bank first memory 321, the write control circuit 72 outputs the increment signal to the write pointer 75.

When determining that the last data of the data group is written to the first bank first memory 311 or to the second bank first memory 321, the write control circuit 72 determines whether the first data of the next data group follows the last data of the data group without interruption. When determining that the first data of the next data group does not follow the last data of the data group, the write control circuit 72 outputs the increment signal to the write pointer 75.

When determining that the first data of the next data group follows the last data of the data group without interruption, the write control circuit 72 outputs a second memory increment selection signal Lw_WP+1_sel to the write pointer 75. At the same time, the write control circuit 72 outputs the increment signal to the write pointer 75.

When a data presence signal is input from the data information FIFO queue group 74 and the read OK signal OK enters the enable state, the read control circuit 73 starts read control. First, the read control circuit 73 outputs a read queue signal Read_Queue to the data information FIFO queue group 74.

Next, to the read control circuit 73, data length information, in-bank start position information, and start bank position information are input from the data information FIFO queue group 74. The data length information corresponds to the data length of the data group to be read, the in-bank start position information corresponds to the memory in which the first data of the data group to be read is stored, and the start bank position information corresponds to the bank in which the first data of the data group to be read is stored. The read control circuit 73 calculates the read period of time, which is the period of time during which data group stored in the buffer 30 is read, based on the data length information input from the data information FIFO queue group 74.

Next, the read control circuit 73 determines whether the bank in which the first data of the data group to be read is stored is selected as the write bank. At this time, the read control circuit 73 performs the determination, based on the output signal of the write bank switching switch 71 and the start bank position information input from the data information FIFO queue group 74. When it is determined that the bank in which the first data of the data group to be read is stored is selected as the write bank, the read control circuit 73 starts read after standing by for a time corresponding to one cycle of the reference period. When it is determined that the bank in which the first data of the data group to be read is stored is not selected as the write bank, the read control circuit 73 starts read. When the read enable signal Data_Read_Enable is 1 and the second bank 32 is selected as the write bank, the signal output from the first read enable terminal RE1 is 1. When the read enable signal Data_Read_Enable is 1 and the first bank 31 is selected as the write bank, the signal output from the second read enable terminal RE2 is 1.

While reading data group stored in the buffer 30, the read control circuit 73 determines whether data stored in the first bank second memory 312 or in the second bank second memory 322 is read. When determining that data stored in the second bank second memory 322 is read when the first data of the data group is read from the first bank 31, the read control circuit 73 outputs the increment signal to the read pointer 76. Further, when determining that data stored in the first bank second memory 312 is read when the first data of the data group is read from the second bank 32, the read control circuit 73 outputs the increment signal to the read pointer 76.

When reading the last data of the data group, the read control circuit 73 determines whether the last data of the data group is written to the first bank first memory 311 or to the second bank first memory 321. When determining that the last data of the data group is not written to the first bank first memory 311 or to the second bank first memory 321, the read control circuit 73 outputs the increment signal to the read pointer 76.

When determining that the last data of the data group is written to the first bank first memory 311 or to the second bank first memory 321, the read control circuit 73 determines the memory in which the first data of the next data group is stored. The read control circuit 73 determines whether the first data of the next data group is stored in the second memory of the bank in which the last data of the previous data group is stored. In other words, when determining that the last data of the data group is written to the first bank first memory 311, the read control circuit 73 determines whether the first data of the next data group is stored in the first bank second memory 312. Further, when determining that the last data of the data group is written to the second bank first memory 321, the read control circuit 73 determines whether the first data of the next data group is stored in the second bank second memory 322. When determining that the first data of the next data group is not stored in the second memory of the bank in which the last data of the data group is stored, the read control circuit 73 outputs the increment signal to the read pointer 76.

When determining that the first data of the next data group is stored in the second memory of the bank in which the last data of the data group is stored, the read control circuit 73 outputs a second memory increment selection signal Lw_RP+1_sel to the read pointer 76. At the same time, the read control circuit 73 outputs the increment signal to the read pointer 76.

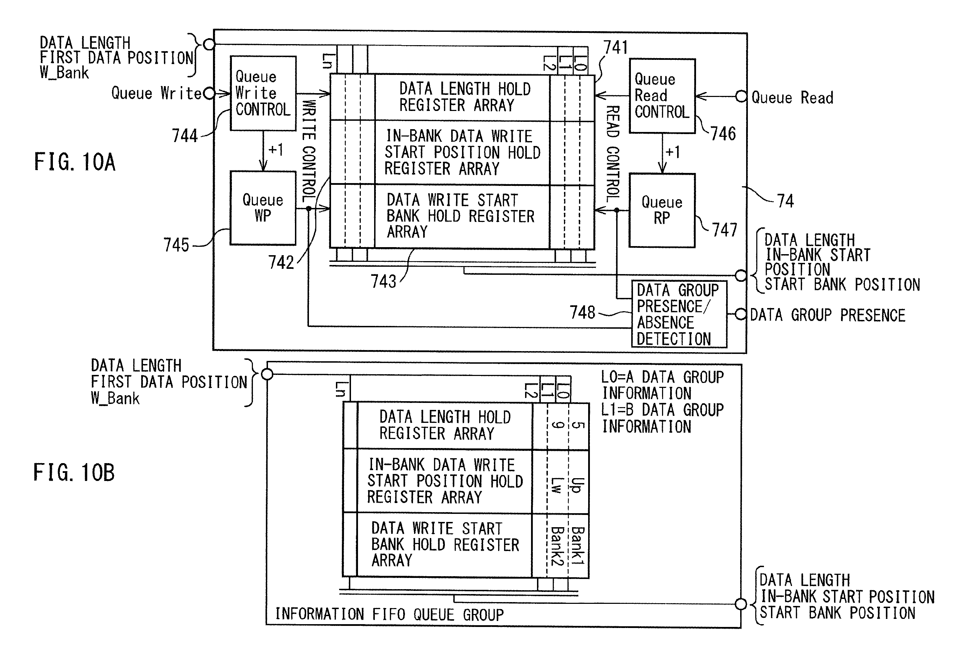

Fig. 10A is an internal circuit block diagram of the data information FIFO queue group 74 and Fig. 10B is a diagram illustrating an example of data stored in the data information FIFO queue group 74.

The data information FIFO queue group 74 has a data length hold register array 741, an in-bank data write start position hold array 742, and a data write start bank hold array 743. The data information FIFO queue group 74 further has a queue write control unit 744, a queue write pointer 745, a queue read control unit 746, a queue read pointer 747, and a data group presence/absence detection unit 748.

The data length hold register array 741 stores data length information corresponding to the data length of each of the data groups to be input to the data transfer device 2. The in-bank data write start position hold array 742 stores in-bank write start position information corresponding to the memory to which the first data of each of the data groups to be input to the data transfer device 2 is written. The data write start bank hold array 743 stores start bank position information corresponding to the bank to which the first data of each of the data groups to be input to the data transfer device 2 is written.

The queue write control unit 744 controls the write of information to the data length hold register array 741, the in-bank data write start position hold array 742, and the data write start bank hold array 743. When the queue write signal Queue_Write is input from the data write control circuit 72, the queue write control unit 744 starts write in each array.

The queue write control unit 744 determines the data length of the input data group, based on the data from the input data clock transfer circuit 10 and outputs data length information corresponding to the data length to the data length hold register array 741.

The queue write control unit 744 determines whether the first data of the data group is input as the higher-order data Up_W_Data or the lower-order data Lw_W_Data, based on the data from the input data clock transfer circuit 10. Next, the queue write control unit 744 outputs in-bank start position information corresponding to the memory to which the first data of the data group is written to the in-bank data write start position hold array 742, based on the determination result.

The queue write control unit 744 determines whether the first data of the data group is stored in the first bank 31 or in the second bank 32, based on the signal from the write bank switching switch 71. The queue write control unit 744 outputs start bank position information corresponding to the bank to which the first data of the data group is written to the data write start bank hold array 743, based on the determination result.

When ending the write processing in each array, the queue write control unit 744 outputs the increment signal to the queue write pointer 745.

The queue write pointer 745 increments the queue write address of each array, based on the increment signal input from the queue write control unit 744. The number of addresses of each array corresponds to the number of data groups that the data transfer device 2 can store.

The queue read control unit 746 controls the read of information from the data length hold register array 741, the in-bank data write start position hold array 742, and the data write start bank hold array 743. When the queue read signal Queue_Read is input from the data read control circuit 73, the queue read control unit 746 outputs data length information, in-bank start position information, and start bank position information stored in a predetermined address to the read control circuit 73.

After outputting data length information, in-bank start position information, and start bank position information to the read control circuit 73, the queue read control unit 746 outputs the increment signal to the queue read pointer 747. The queue read pointer 747 increments the queue read address of each array, based on the increment signal input from the queue read control unit 746.

The data group presence/absence detection unit 748 determines whether there is a data group to be read, based on the queue write address input from the queue write pointer 745 and the queue read address input from the queue read pointer 747. When the queue write address and the queue read address is consistent with each other, the data group presence/absence detection unit 748 determines that there is no data group to be read. On the other hand, when the queue write address and the queue read address is not consistent with each other, the data group presence/absence detection unit 748 determines that there is a data group to be read and outputs the data presence signal to the read control circuit 73.

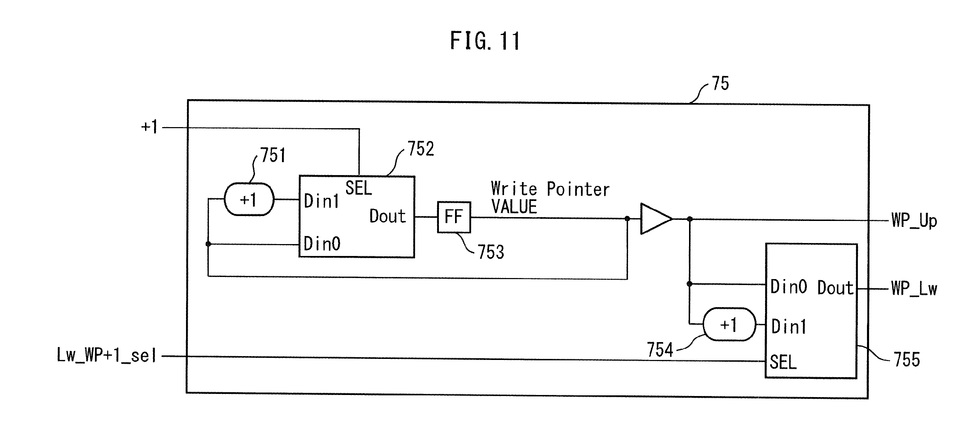

Fig. 11 is an internal circuit block diagram of the write pointer 75.

The write pointer 75 has a first increment unit 751, a first selection unit 752, a latch unit 753, a second increment unit 754, and a second selection unit 755.

The first increment unit 751 outputs the address, which is the incremented write address, to the first selection unit 752. The first selection unit 752 selects the address not incremented and the incremented address, based on the increment signal. When the increment signal is not input, the first selection unit 752 selects the address not incremented and outputs the address not incremented to the latch unit 753. When the increment signal is input, the first selection unit 752 selects the address incremented in the first increment unit 751 and outputs the incremented address to the latch unit 753. The latch unit 753 outputs the input address as the write address in each one cycle of the reference period. The write address output from the latch unit 753 is output to the first bank first memory 311 and to the second bank first memory 321 as a higher-order data write address signal WP_Up.

The second increment unit 754 outputs the address, which is the incremented write address, to the second selection unit 755. The second selection unit 755 selects the address not incremented and the incremented address, based on the second memory increment selection signal Lw_WP+1_sel. When the second memory increment selection signal Lw_WP+1_sel is not input, the second selection unit 755 selects the address not incremented. When the second memory increment selection signal Lw_WP+1_sel is input, the second selection unit 755 selects the address incremented in the second increment unit 754. The write address output from the second selection unit 755 is output to the first bank second memory 312 and to the second bank second memory 322 as a lower-order data write address signal WP_Lw.

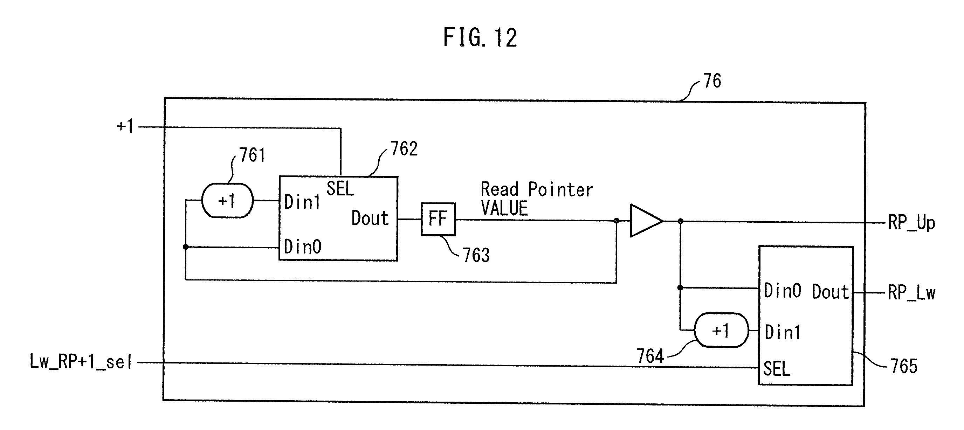

Fig. 12 is an internal circuit block diagram of the read pointer 76.

The read pointer 76 has a first increment unit 761, a first selection unit 762, a latch unit 763, a second increment unit 764, and a second selection unit 765.

The first increment unit 761 outputs the address, which is the incremented read address, to the first selection unit 762. The first selection unit 762 selects the address not incremented and the incremented address, based on the increment signal. When the increment signal is not input, the first selection unit 762 selects the address not incremented and outputs the address not incremented to the latch unit 763. When the increment signal is input, the first selection unit 762 selects the address incremented in the first increment unit 761 and outputs the incremented address to the latch unit 763. The latch unit 763 outputs the input address as the read address in each one cycle of the reference period. The read address output from the latch unit 763 is output to the first bank first memory 311 and to the second bank first memory 321 as a higher-order data read address signal RP_Up.

The second increment unit 764 outputs the address, which is the incremented read address, to the second selection unit 765. The second selection unit 765 selects the address not incremented and the incremented address, based on the second memory increment selection signal Lw_RP+1_sel. When the second memory increment selection signal Lw_RP+1_sel is not input, the second selection unit 765 selects the address not incremented. When the second memory increment selection signal Lw_RP+1_sel is input, the second selection unit 765 selects the address incremented in the second increment unit 764. The read address output from the second selection unit 765 is output to the first bank second memory 312 and to the second bank second memory 322 as a lower-order data read address signal RP_Lw.

The control circuit 70 controls the first bank 31 and the second bank 32 so that the data groups input to the input data clock transfer circuit 10 are sequentially stored in the first bank 31 and in the second bank 32 and the stored data groups are sequentially read and output from the output data clock transfer circuit 50. The control circuit 70 writes double length data output from the input data clock transfer circuit 10 in an address position after the address position in which the last data of the data group stored immediately before in the first bank 31 and the second bank 32 is stored. When writing the double length data output from the input data clock transfer circuit 10, the control circuit 70 stores the data groups in order from the first bank 31 or from the second bank 32 to which the data group can be written, based on the signal output from the write bank switching switch 71.

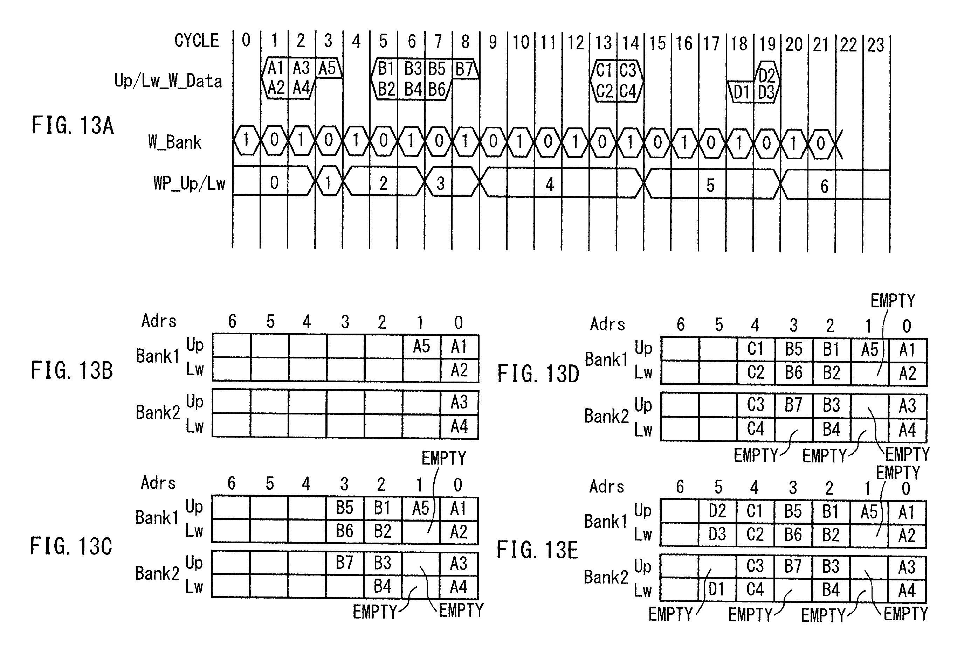

Fig. 13A is a diagram illustrating a time chart of the data transfer device 2 and Figs. 13B to 13E are diagrams each illustrating the bank and the memory to which the data illustrated in Fig. 13A is written. In Fig. 13A, one cycle corresponds to the reference period and "Up/Lw_Data" indicates data output from the input data clock transfer circuit 10. "W_Bank" indicates data output from the write bank switching switch 71 and "Wp_Up/Lw" indicates the write address data of the first memory and the second memory output from the write pointer 75. In Figs. 13B to 13E, "Up" and "Lw" of "Bank1" indicate the first bank first memory 311 and the first bank second memory 312, respectively. "Up" and "Lw" of "Bank2" indicate the second bank first memory 321 and the second bank second memory 322, respectively.

In the time chart illustrated in Fig. 13A, the first data group of A1 to A5, the second data group of B1 to B7, the third data group of C1 to C4, and the fourth data group of D1 to D3 are input to the data transfer device 2.

In the data transfer device 2, after each of the data groups is written, the write address is incremented, and therefore despite the bank and the memory to which the last data of the data group stored immediately before, it is possible to write data to the memory of the write enable bank. The data transfer device 2 does not reduce latency performance, since it is possible to write data to the write enable bank.

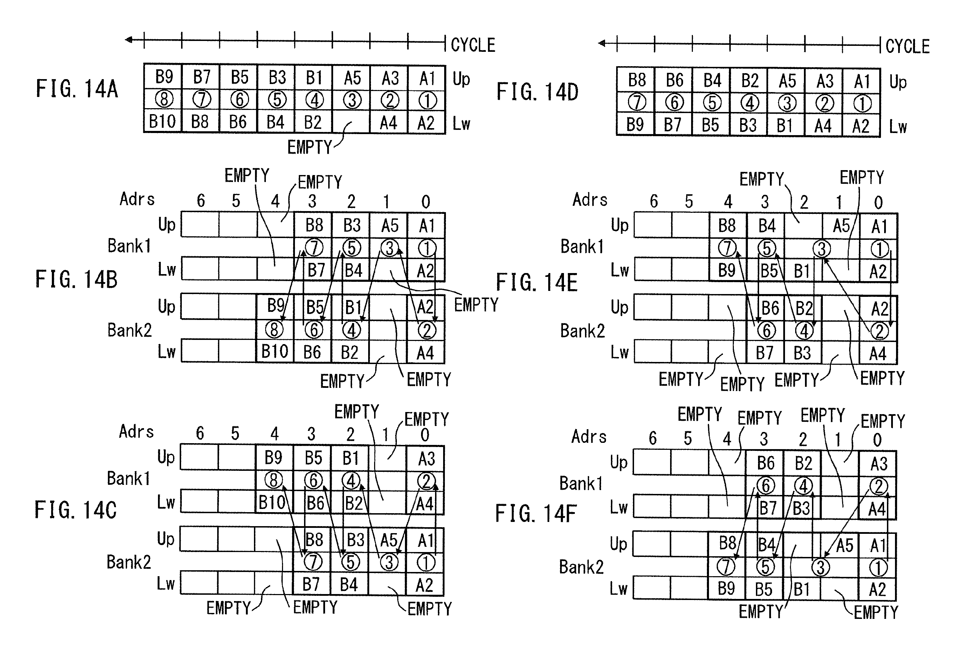

Fig. 14A is a diagram illustrating an example of the data groups to be input to the data transfer device 2. Fig. 14B is a diagram illustrating an example in which the data groups illustrated in Fig. 14A are stored from the first bank 31 and Fig. 14C is a diagram illustrating an example in which the data groups illustrated in Fig. 14A are stored from the second bank 32. Fig. 14D is a diagram illustrating another example of the data groups to be input to the data transfer device 2. Fig. 14E is a diagram illustrating an example in which the data groups illustrated in Fig. 14D are stored from the first bank 31 and Fig. 14F is a diagram illustrating an example in which the data groups illustrated in Fig. 14D are stored from the second bank 32.

As illustrated in Fig. 14B and Fig. 14C, when storing the data group including an odd number of pieces of data, the data transfer device 2 stores data only in one of the memories included in the bank and the other memory enters the empty state. In the examples illustrated in Fig. 14B and Fig. 14C, the number of cycles of the write period of time is an odd number, and therefore data is stored only in the memory of one of the banks and the memory of the other bank enters the empty state.

Fig. 14D illustrates an example in which the last data of the data group is written to the first bank first memory 311 or to the second bank first memory 321 and the first data of the next data group follows the last data of the data group without interruption.

In the example illustrated in Fig. 14E, the last data A5 of the first data group of A1 to A5 is written in address 1 of the first bank first memory 311 and the first data B1 of the second data group of B1 to B9 is written in address 2 of the first bank second memory 312. In other words, the address in which the first data B1 of the second data group of B1 to B9 is written is address 2, which is the next address of address 1 in which the last data A5 of the first data group of A1 to A5 is written.

In the example illustrated in Fig. 14F, the last data A5 of the first data group of A1 to A5 is written in address 1 of the second bank first memory 321 and the first data B1 of the second data group of B1 to B9 is written in address 2 of the second bank second memory 322. In other words, the address in which the first data B1 of the second data group of B1 to B9 is written is address 2, which is the next address of address 1 in which the last data A5 of the first data group of A1 to A5 is written.

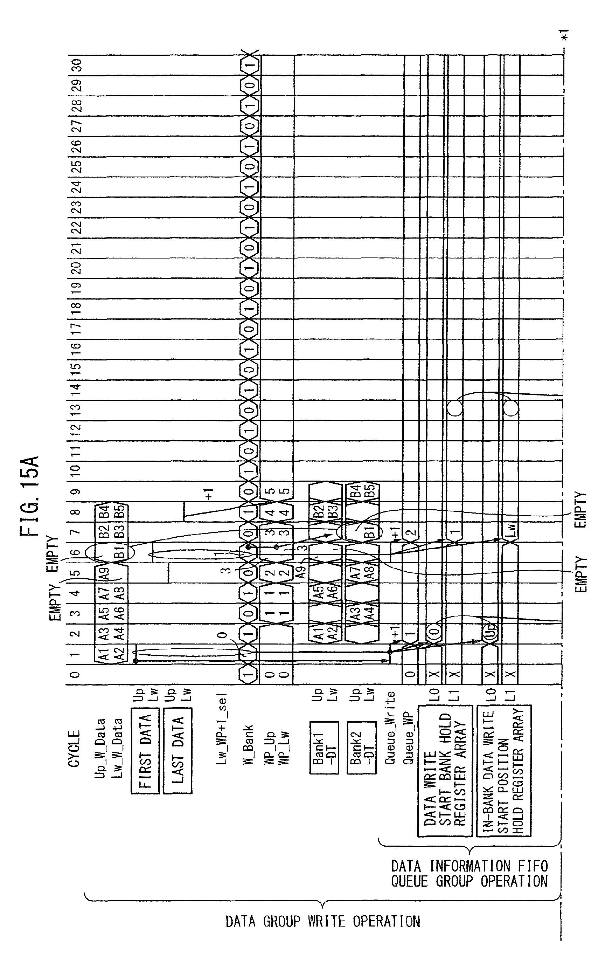

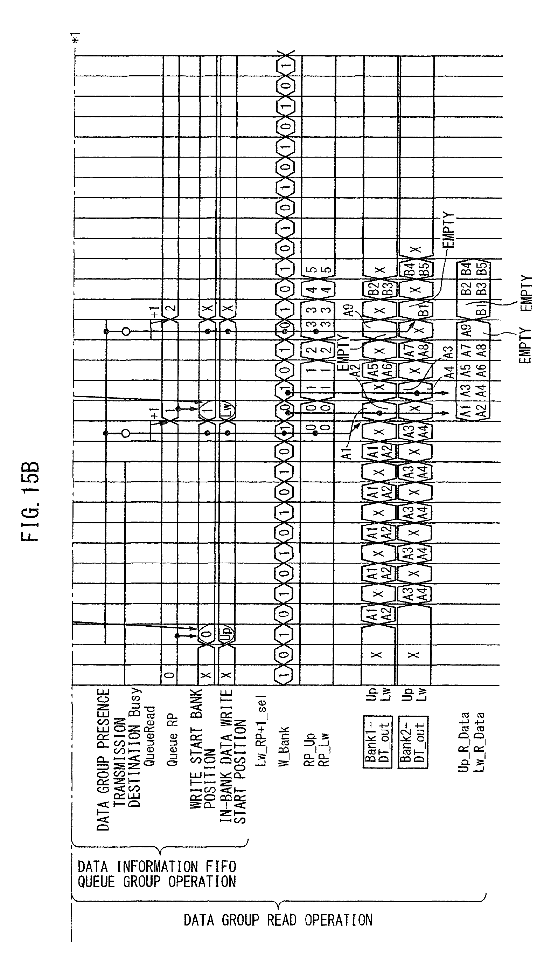

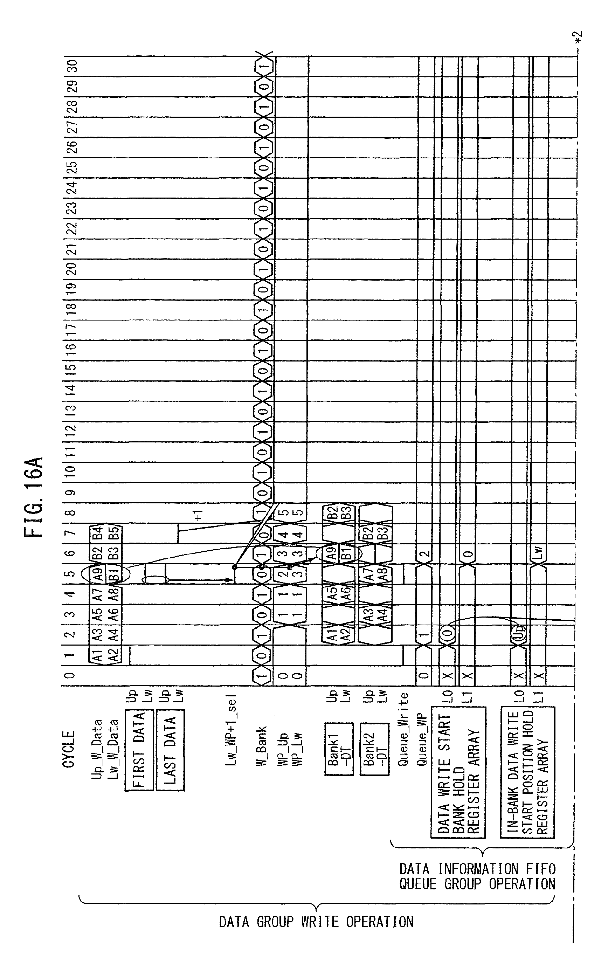

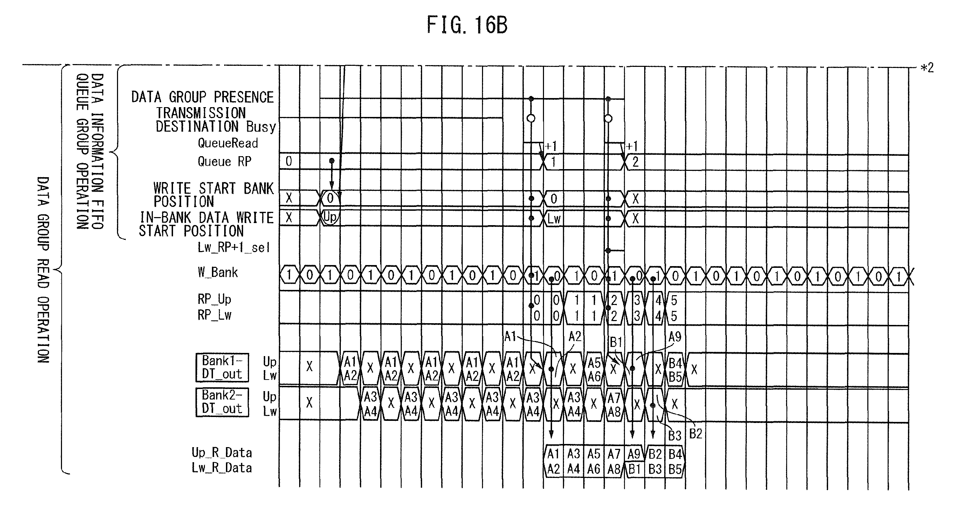

Figs. 15A and 15B are diagrams each illustrating the time chart in which last data A9 of a first data group of A1 to A9 and first data B5 of a second data group of B1 to B5 are not continuous. Figs. 16A and 16B are diagrams each illustrating the time chart in which the last data A9 of the first data group of A1 to A9 and the first data B1 of the second data group of B1 to B5 are continuous.

In the time charts illustrated in Fig. 15A and Fig. 15B, the last data A9 of the first data group of A1 to A9 is stored in the first bank first memory 311, however, the last data A9 of the first data group of A1 to A9 and the first data B1 of the second data group of B1 to B5 are not continuous. In this case, the write control circuit 72 does not output the second memory increment selection signal Lw_WP+1_sel to the write pointer 75, and therefore the first data B1 of the second data group of B1 to B5 is written to the second bank second memory 322.

On the other hand, in the time charts illustrated in Fig. 16A and Fig. 16B, the last data A9 of the first data group of A1 to A9 is stored in the first bank first memory 311 and the last data A9 of the first data group of A1 to A9 and the first data B1 of the second data group of B1 to B5 are continuous. In this case, the write control circuit 72 outputs the second memory increment selection signal Lw_WP+1_sel to the write pointer 75 and the first data B1 of the second data group of B1 to B5 is written to the first bank second memory 312.

In the time charts illustrated in Fig. 15A and Fig. 15B, the last data A9 of the first data group of A1 to A9 is stored in address 2 of the first bank first memory 311 and the first data B1 of the second data group of B1 to B5 is stored in address 3 of the second bank second memory 322. In this case, the read control circuit 73 does not output the second memory increment selection signal Lw_RP+1_sel to the read pointer 76. Since the read control circuit 73 does not output the second memory increment selection signal Lw_RP+1_sel, the data transfer device 2 reads the first data B1 of the second data group of B1 to B5 in the next cycle after reading the last data A9 of the first data group of A1 to A9.

In the time charts illustrated in Fig. 16A and Fig. 16B, the last data A9 of the first data group of A1 to A9 is stored in address 2 of the first bank first memory 311 and the first data B1 of the second data group of B1 to B5 is stored in address 3 of the first bank second memory 312. In this case, the read control circuit 73 outputs the second memory increment selection signal Lw_RP+1_sel to the read pointer 76. Since the read control circuit 73 outputs the second memory increment selection signal Lw_RP+1_sel, the data transfer device 2 reads the first data B1 of the second data group of B1 to B5 in the cycle in which the data transfer device 2 reads the last data A9 of the first data group of A1 to A9.

The data transfer devices 1 and 2 have the input data clock transfer circuit 10 and the buffer 30. The input data clock transfer circuit 10 doubles the data width by sequentially allocating data included in the input data group to the higher-order data and to the lower-order data and outputs the higher-order data and the lower-order data in each one cycle of the reference period, which is a period twice that of the input data. The buffer has the first bank and the second bank having the first memories 311 and 321, and the second memories 312 and 322, respectively. The data transfer devices 1 and 2 write the higher-order data and the lower-order data to the first memories 311 and 321, and to the second memories 312 and 322, respectively, and therefore it is possible to write data having a clock period twice the write time of the memories of the first bank and the second bank.

Further, in the data transfer devices 1 and 2, when the first bank 31 is in the write state, the second bank 32 is in the read state and when the second bank 32 is in the write state, the first bank 31 is in the read state. In the data transfer device, when one of the memories is in the write state, the other memory is in the read state, and therefore it is possible for the data transfer device to perform write and read operations at the same time.

It may also be possible to use the data transfer devices 1 and 2 as a buffering circuit for storing data.

## Claims

1. A data transfer device for sequentially writing and storing data groups and reading and outputting the data groups in the order of storage, the data transfer device comprising:
a first bank having a first bank first memory and a first bank second memory to and from which write and read operations are performed in a reference period, the first bank alternately changing to a write state and to a read state in each of the reference periods;
a second bank having a second bank first memory and a second bank second memory to and from which write and read operations are performed in the reference period, the second bank alternately changing to a write state and to a read state in a phase opposite to that of the first bank; and
a control circuit configured to perform control so that data groups that are input are sequentially stored in the first bank and in the second bank and the stored data groups are read sequentially.

2. The data transfer device according to claim 1, further comprising:
an input data clock transfer circuit configured to combine two pieces of data input in a data period half the reference period and to output the two pieces of data as double length data including higher-order data and lower-order data; and
an output data clock transfer circuit configured to read the double length data stored in the first bank and the second bank in the reference period and to output the double length data in the data period after dividing the double length data into the higher-order data and the lower-order data.

3. The data transfer device according to claim 2, wherein
the control circuit writes data groups in order from the first bank or the second bank to which the data group can be written when the input data clock transfer circuit outputs the double length data in an address position after the address position in which the last data of the data group stored immediately before in the first bank and the second bank is stored.

4. The data transfer device according to claim 1, wherein
the control circuit has a write bank switching switch configured to alternately output a first bank write enable signal to enable write to the first bank and a second bank write enable signal to enable write to the second bank in each one cycle of the reference period and a write pointer configured to increment the write address positions of the first bank and the second bank,
the control circuit determines which of the first bank and the second bank is in the write enable state, based on the first bank write enable signal and the second bank write enable signal upon receipt of the first data of the data group and:
writes the first data to the first bank first memory when the first bank is in the write enable state and the first data is allocated to the higher-order data;
writes the first data to the first bank second memory when the first bank is in the write enable state and the first data is allocated to the lower-order data;
writes the first data to the second bank first memory when the second bank is in the write enable state and the first data is allocated to the higher-order data; and
writes the first data to the second bank second memory when the second bank is in the write enable state and the first data is allocated to the lower-order data,
the control circuit stores the bank and the memory to which the first data is written, and
the write pointer increments the write address after writing the last data of the data group and sets the next address of the address to which the last data is written as a write start address of the next data group.

5. The data transfer device according to claim 4, wherein
the control circuit determines whether the last data of the data group is written to the first bank first memory or to the second bank first memory when writing the last data of the data group and at the same time, determines whether the first data of the next data group follows the last data of the data group without interruption and:
writes the first data of next data group to the first bank second memory when the last data of the data group is written to the first bank first memory and the first data of the next data group follows the last data of the data group without interruption; and
writes the first data of next data group to the second bank second memory when the last data of the data group is written to the second bank first memory and the first data of the next data group follows the last data of the data group without interruption.

6. The data transfer device according to claim 2, wherein
the control circuit sequentially writes the data group in the position following without interruption the storage position of the last data of the data group stored immediately before in the first bank and the second bank.

7. The data transfer device according to claim 6, wherein
the control circuit writes:
the first data of the data group to the first bank second memory when the last data of the data group stored immediately before is stored in the first bank first memory;
the first data of the data group to the second bank first memory when the last data of the data group stored immediately before is stored in the first bank second memory;
the first data of the data group to the second bank second memory when the last data of the data group stored immediately before is stored in the second bank first memory; and
the first data of the data group to the first bank first memory when the last data of the data group stored immediately before is stored in the second bank second memory.

8. The data transfer device according to claim 7, further comprising a timing adjustment circuit having:
a first delay circuit configured to output first delay data in which the higher-order data is turned into lower-order data and the lower-order data is turned into higher-order data by delaying the lower-order data by a time corresponding to one cycle of the reference period;
a second delay circuit configured to output second delay data in which the higher-order data and the lower-order data are delayed by a time corresponding to one cycle of the reference period; and
a third delay circuit configured to output third delay data in which the higher-order data is turned into lower-order data by delaying the higher-order data by a time corresponding to one cycle of the reference period and the lower-order data is turned into higher-order data by delaying the lower-order data by a time corresponding to two cycles of the reference period, wherein
the control circuit determines a bank and a memory to which the first data of the data group is written, based on the bank and the memory to which the first data of the data group stored immediately before is written and the data length of the data group stored immediately before, and
the control circuit outputs:
the higher-order data and the lower-order data from the timing adjustment circuit when determining that the first data of the data group is written to the first bank first memory;
the first delay data from the timing adjustment circuit when determining that the first data of the data group is written to the first bank second memory;
the second delay data from the timing adjustment circuit when determining that the first data of the data group is written to the second bank first memory; and
the third delay data from the timing adjustment circuit when determining that the first data of the data group is written to the second bank second memory.

9. A buffering circuit comprising:
a first bank having a first bank first memory and a first bank second memory to and from which write and read are performed in a reference period, the first bank alternately changing to a write state and to a read state in each of the reference periods;
a second bank having a second bank first memory and a second bank second memory to and from which write and read operations are performed in the reference period, the second bank alternately changing to a write state and to a read state in a phase opposite to that of the first bank; and
a control circuit configured to perform control so that data groups that are input are sequentially stored in the first bank and in the second bank and the stored data groups are read sequentially.

10. A buffering method using a buffering circuit having:
a first bank having a first bank first memory and a first bank second memory to and from which write and read operations are performed in a reference period, the first bank alternately changing to a write state and to a read state in each of the reference periods;
a second bank having a second bank first memory and a second bank second memory to and from which write and read operations are performed in the reference period, the second bank alternately changing to a write state and to a read state in a phase opposite to that of the first bank; and
a control circuit configured to perform control so that data groups that are input are sequentially stored in the first bank and in the second bank and the stored data groups are read sequentially, the buffering method comprising:
alternately outputting a first bank write enable signal to enable write to the first bank and a second bank write enable signal to enable write to the second bank in each one cycle of the reference period;
determining which of the first bank and the second bank is in the write enable state, based on the first bank write enable signal and the second bank write enable signal when receiving the first data of the data group;
writing the first data to the first bank first memory when the first bank is in the write enable state and the first data is allocated to higher-order data;
writing the first data to the first bank second memory when the first bank is in the write enable state and the first data is allocated to lower-order data;
writing the first data to the second bank first memory when the second bank is in the write enable state and the first data is allocated to higher-order data;
writing the first data to the second bank second memory when the second bank is in the write enable state and the first data is allocated to lower-order data,
storing the bank and the memory to which the first data is written, respectively, and
incrementing the write address after writing the last data of the data group and setting the next address of the address in which the last data of the data group is written as a write start address of the next data group.
